Europäisches Patentamt

European Patent Office

Office européen des brevets

(19)

(11) EP 0 859 282 A1

(12) **EUROPEAN PATENT APPLICATION**

(43) Date of publication:
19.08.1998 Bulletin 1998/34

(51) Int Cl.⁶: G03F 7/022

(21) Application number: 98301153.7

(22) Date of filing: 17.02.1998

(84) Designated Contracting States:
AT BE CH DE DK ES FI FR GB GR IE IT LI LU MC NL PT SE
Designated Extension States:
AL LT LV MK RO SI

(30) Priority: 18.02.1997 US 801682
30.01.1998 US 16003

(71) Applicant: MORTON INTERNATIONAL, INC.
Chicago, Illinois 60606 (US)

(72) Inventors:
• Hawkins, Robert E.
Irvine, California 92606 (US)
• Briguglio, James J.
Balboa, California 92661 (US)

(74) Representative:
Bankes, Stephen Charles Digby et al
BARON & WARREN
18 South End
Kensington
London W8 5BU (GB)

(54) **Positive-tone photoimageable crosslinkable coating**

(57) The imaged portion of a positive-tone photoimageable dielectric coating composition comprising a combination of a novolac resin and a naphthoquinonediazide is soluble in an aqueous alkaline developer and the developed coating is rendered highly stable, chemically and thermally, by the presence therein of a crosslinkable resin and dicyandiamide or a thermally labile halogen-containing as a curing catalyst while heating the coating to cure it.

EP 0 859 282 A1

## Description

The present invention is directed to a positive-tone photoimageable dielectric composition which forms the permanent innerlayers of a multilayer printed circuit board, and to a method for forming such a board. It is also directed to a novel method for manufacturing multilayer printed circuit boards by the selective plating of the dielectric layers, eliminating the need for the standard copper foil inner layers, and the photodefinition of vias, thereby eliminating the need for drilled holes in most instances. The invention is also directed to the use of the photoimageable dielectric composition as a solder mask.

Multilayer printed circuit boards have traditionally comprised a stack of individual printed circuit boards or innerlayers separated by dielectrical material. The circuitry of the several innerlayers is electrically connected by bored and plated-through holes. Multilayer printed circuit boards provide circuitry in a three-dimensional array and are therefor advantageously space-saving, relative to individual printed circuit boards, which provide at most two layers of circuitry on a two-sided board.

These printed circuit boards are commonly provided with internal ground and power planes. These internal planes are frequently solid sheets of copper interrupted only by clearance holes (the perforations required for electrically isolating the through hole pattern of the printed circuit board). Ground and power planes provide power voltage and current and ground connections for the components of the multilayer printed circuit. A second function of the ground and power planes is to provide electromagnetic shielding for the multilayer printed circuit board and reduce the electromagnetic and radio frequency interference. Multiple ground and power planes and additional ground planes on the surface layers with the conductive pattern are common.

Multilayer circuits enable formation of multiple circuits in minimal volume. They typically comprise a stack of layers with layers of signal lines (conductors) separated from each other by dielectric layers having plated holes known as vias providing electrical interconnections between the layers.

Current processes for fabricating multilayer boards are extensions of methods used for fabricating double sided boards. The method comprises fabricating of separate innerlayers having circuit patterns disposed over their surface. A photosensitive material is coated over the copper surfaces of a copper clad innerlayer material, imaged, developed and etched to form a conductor pattern in the copper cladding protected by the photosensitive coating. After etching, the photosensitive coating is stripped from the copper leaving the circuit pattern on the surface of the base material. Following formation of the innerlayers, a multilayer stack is formed by preparing a lay up of innerlayers, ground plane layers, power plane layers, etc., typically separated from each other by a dielectric prepeg (a layer consisting of glass cloth impregnated with partially cured material, typically a B-stage epoxy resin). The outer layers of the stack comprise copper clad glass filled epoxy board material with the copper cladding comprising exterior surfaces of the stack. The stack is laminated to form a monolithic structure using heat and pressure to fully cure the B-stage resin.

Interconnections or through-holes, buried vias and blind hole interconnections are used to connect circuit layers within a multilayer board. The buried vias are plated through holes connecting two sides of an innerlayer. Blind vias typically pass through one surface of the stack and pass into and stop within the stack. Regardless of the form of interconnections, holes are generally drilled at appropriate locations through the stack, catalyzed by contact with a plating catalyst and metallized, typically with electroless copper overplated with electrolytic copper, to provide electrical contact between circuit innerlayers.

The uses, advantages and fabricating techniques for the manufacture of multilayer boards are described by Coombs, Printed Circuits Handbook, McGraw Hill Book Company, New York, 2nd edition, pp. 20-3 to 23-19, 1979, incorporated herein by reference.

Multilayer boards have become increasingly complex. For example, boards for main frame computers may have as many as 36 layers of circuitry, with the complete stack having a thickness of about 1/4 inch. These boards are typically designed with 4 mil wide signal lines and 12 mil diameter vias for interconnections between signal line layers. For increased densification, it is desired to reduce signal lines to a width of 2 mils or less and vias to a diameter of 2 to 5 mill or less.

The photoimageable dielectric coatings for printed circuit boards on the leading edge of the technology must be capable of being processed in a minimum number of steps. Their dielectric and photolithographic properties, flexibility, and intercoat adhesion also must be excellent. A low photospeed, high moisture resistance, and good adhesion to a plated metal are also important properties of such coatings.

This invention is directed to positive-tone photosensitive dielectric compositions because of the resolution limitations, limited aspect ratio, limited process latitudes (exposure, development), and the leaching of organics during plating cycles experienced during the use of the typical negative acting photoresists.

The processing of positive acting photoresists generally follows the sequence of applying a solution of the resist to a copper foil laminated to an epoxy resin base, drying and baking the resist to expel the solvent, exposing the resist to actinic radiation through a patterned photomask to define an image, dissolving the exposed portions of the resist in an alkaline developer to delineate the image, rinsing, and in some instances post-baking the imaged resist. The areas void of resist, comprised of exposed copper substrate, are then either etched or electroplated. As was said above, the use of copper foil is eliminated by the method of this invention.

U.S. Patent No. 4,672,020 (3M) teaches a multilayer dry film photoresist comprising a positive acting photoresist composition comprising an o-quinone diazide in a phenol formaldehyde resin as the binder in the first functional layer. The binder becomes more soluble in an aqueous alkaline solution upon exposure to actinic radiation.

Now we have found that the post-develop image of a positive-tone novolac/diazonaphthoquinone composition may be made highly stable, both chemically and thermally, by the incorporation of crosslinkable resins, such as epoxy resins, and a thermal curing catalyst.

It is an object of this invention, therefore, to provide a thermally crosslinkable, positive-tone, photoimageable dielectric composition which may be used as a solder mask and as an innerlayer in multilayer printed circuit boards.

It is a related object of this invention to provide a novel method for manufacturing multilayer printed circuit boards by the selective plating of the dielectric layers, eliminating the need for the standard copper foil inner layers.

It is another related object of this invention to provide a positive-tone, photoimageable dielectric composition whose post-develop image is highly stable, both chemically and thermally.

It is still another related object of this invention to provide a multilayer printed circuit board having permanent innerlayers made of a positive-tone photoimaged dielectric composition.

It is yet another object of this invention to provide a method for making a multilayered printed circuit board by which the vias are photodefined.

These and other objects of the invention which will become apparent from the following description are achieved by a photoimageable dielectric composition comprising a novolac resin, a crosslinkable resin, a naphthoquinonediazide, and a curing catalyst selected from the group consisting of dicyandiamide and a thermally labile halogen-containing compound.

To better understand the invention, the following definitions have been adopted:

Photoimageable dielectric coating means an organic dielectric coating composition capable of imaging by exposure to activating radiation and development to yield a relief image and become an integral part of a multilayer board. It may be applied as a liquid coating composition and dried to a tack free coating or as a dry film. Preferably, the dielectric constant of the coating does not exceed 4.5.

Imaged opening means a relief image of (1) recesses or channels defining a pattern of conductors or (2) openings for interconnections, within a dielectric coating. Imaged openings are subsequently selectively metallized whereby metal is contained within the recesses of the relief image.

Substantially means largely but not wholly that which is being specified so that the difference is inconsequential.

The major portion of the binder for the photoimageable dielectric composition of this invention is the novolac resin, which imparts an aqueous base solubility to the composition and serves as the backbone thereof which reacts with the crosslinkable resins during the thermal crosslinking of the innerlayers. Novolac resins are commonly known products of the acid catalyzed condensation of a phenol and an aldehyde such as formaldehyde, acetaldehyde, and furfural. The term phenol is used herein to mean phenols as a class and includes alkylphenols such as cresol, the xylenols, and butylated phenolic novolacs. Suitably, the amount of the novolac resin may be from about 30 to about 80 % by weight of the total composition, but it is preferred to use from about 45 to 70%, of the novolac in the photoimageable dielectric coating composition of this invention. A preferred photoimageable dielectric coating composition contains about 46 % by weight of the cresol novolac resin. The resins are widely available from many chemical suppliers.

The amount of crosslinkable resin for curing the novolac resins in the photoimageable dielectric composition to make the innerlayers of the multiple layered printed circuit board of this invention may be from about 5 to about 40 % but it is preferably from about 10 to about 30 and more preferably from about 15 to about 25 % by weight of the total composition. Epoxy resins in general are suitable as such a crosslinking agent for the purposes of this invention. Epoxy novolacs are a particular example of the epoxy resins. A preferable amount of such a multifunctional novolac is from about 5 to about 20 %, more preferably, from about 8 to about 12 %, and still more preferably, about 10 % by weight.

A photoimageable dielectric composition of this invention may contain about 20 % by weight of an epoxidized polybutadiene sold by Elf Atochem under the trademark POLY BD 605 and having a viscosity of 25000 mPa.s (25000 cps) at 25°C and an epoxy equivalent weight of 260.

In a preferred photoimageable dielectric coating composition of this invention, a butylated phenolic novolac is used along with an epoxidized novolac resin. The butylated phenolic novolac imparts flexibility to the cured photoimageable dielectric coating of this invention and it imparts a printout image in conjunction with the photoactive diazonaphthoquinone compound. It may be used in amounts of from about 5 to about 30 %, preferably from about 5 to about 20 %, more preferably from about 8 to about 12 %, and still more preferably, about 10 % of the total weight of the coating composition of this invention.

The naphthoquinonediazide is the photoactive compound which imparts a positive-tone image to the photoimageable dielectric coating of this invention. Examples of the naphthoquinonediazide include, without limitation, naphthoquinone-1,2-diazide-5-sulfochloride, its 4-sulfochloride isomer, and diazoquinone sulfonyl esters of trihydroxy benzophenone. An isomeric mixture of 2,1,5-diazoquinone sulfonyl esters of trihydroxy benzophenone (hereinafter called 215DNQTHB) is available from ChemDesign Corporation of Fitchburg, Massachusetts. Upon irradiation with ultraviolet light such photoactive compounds cause the dielectric coating composition to become soluble in aqueous alkaline solutions. Suitably, from about 5 to about 30 % of the diazonaphthoquinone may be used but it is preferable to use from about 10 to about 20% by weight of the total weight in formulating the photoimageable dielectric coating composition of this invention. A preferred composition contains about 10% of the diazonaphthoquinone compound.

In this invention, a strong Lewis acid is generated when the thermally labile, halogen-containing curing catalyst is heated in the photoimageable dielectric coating composition, thereby catalyzing the condensation of the novolac resins with the crosslinkable resins therein and thus effecting a cure of the imaged innerlayer without the need for an ultraviolet radiation curing step. The thermally labile, halogen-containing curing catalyst is exemplified by diaryliodonium hexafluorantimonate (or DAI HFA), tribromomethylphenyl sulfone, trichloroacetamide, bis-chloroimidazole, 2,4-(trichloromethyl)-4-methoxyphenyl-6-triazine, 2,4-(trichloromethyl)-4-methoxynaphthyl-6-triazine, and 2,4-(trichloromethyl)-piperonyl-6-triazine, all of which are commercially available. Diaryliodonium hexafluorantimonate is sold under the trademark SarCat as a cationic photoinitiator by the Sartomer Company, Inc. The Sar-Cat CD-1012 product is distinguished by a hydroxymyristyloxy group attached to one of two phenyl groups. We have found that low levels, on the order of from about 0.1 to about 2 % by weight, of the thermal curing catalyst are effective in the curing of the coating without substantially impeding the dissolution of the coating to yield a positive image but that higher levels yield a negative tone image. The amount of such an acid generating catalyst is preferably from about 0.5 to about 1.5 % and more preferably from about 1 to about 1.5 % by weight of the total weight of the photoimageable dielectric coating composition of this invention.

Dicyandiamide is also useful as a curing catalyst in the photoimageable dielectric coating composition of this invention. From about 0.1 to about 2 % by weight of the total weight of the composition is suitable.

Melamine and oligomers and polymers thereof such as the melamine-formaldehyde resins as well as benzoguanamine-formaldehyde resins, urea-formaldehyde resins, and glycoluril-formaldehyde resins and combinations of said resins are also suitable as crosslinkers for the purposes of this invention. The melamine, benzoguanamine, and glycoluril resins are available under the trademark CYMEL and the urea resins are available under the trademark BEETLE. From about 5 to about 30 weight percent of the total solids in the composition is suitable.

Fillers may be used in amounts of from about 2 to about 40 % by weight of the total composition in order to control the flow of resins therein while the composition is being cured at elevated temperatures. Fumed silica such as that sold under the trademarks CAB-O-SIL and SYLOID is an example of a useful filler. The CAB-O-SIL M-5 silica is particularly useful. Aluminum oxide, exemplified by Degussa's Aluminum Oxide C, may be used at levels of about 30 % by weight as a flow control aid as well as to improve the resistance of the dielectric to permanganate during swell and etch processing. A quartz and kaolinite mixture sold under the trademark SILLITIN by Hoffman is useful in this invention to improve the adhesion of the dielectric to copper. Silanes and titanates may be used in coupling the fillers with the polymeric matrix and beneficially affect the rheology of the dielectric composition.

A levelling agent such as those sold under the trademark MODAFLOW in the amount of from about 0.2 to about 3 % by weight of the composition of this invention is also useful. A flexibilizing agent such as a poly(vinylmethyl ether) sold under the trademark LUTANOL M is particularly useful in the preparation of a dry film of this invention. An effective amount of the flexibilizing agent is from about 10 to about 20 percent by weight of the total composition.

The dielectric constant of the photoimageable dielectric coating composition of this invention preferably is not greater than 4.5 and more preferably is not greater than 3.5. The resolution is preferably sufficient to provide line widths of 10 mils or less, more preferably 5 mils or less, and still more preferably about 2 mils or less.

The photoimageable dielectric coating composition of this invention may be applied to a substrate as a liquid, then dried, imaged by exposure to UV light and development, and cured or it may be cast as a dry film for storage and subsequent lamination onto a substrate for imaging and curing. The liquid coating composition may be coated onto the surface of a substrate in a variety of ways, including screening, roller coating, curtain coating, and spray coating. A water miscible solvent such as propylene glycol methyl ether acetate may be used in amounts necessary to adjust the viscosity of the photoimageable dielectric coating compositions of this invention to suit the coating method and coating thickness desired. The dielectric substrate for the printed circuit board use may be, for example, a glass-epoxy construction or a polyimide. The coating is tack dried at about 90°C for about 30 minutes and then irradiated through a mask in an image pattern by ultraviolet light having a wave length in the range of from 350 to 450 nm. The total dosage of UV light is from 100 to 800 mj/cm$^2$. The exposed coating is then developed in a 0.17 to 0.3 normal aqueous solution of sodium hydroxide at from 80 to 100° F, rinsed, and cured at a temperature of from 140 to 175° C. for about one hour.

The developer is a strongly basic solution but it may contain sodium carbonate as well as the hydroxide. Sodium metasilicate and trisodium phosphate are also suitable for use in developing solutions. Surfactants are useful in the developer to assist in the removal of the desired portion of the photoimageable dielectric imagewise. The surfactant may be anionic, cationic, non-ionic, or amphoteric.

Dry film may be made by drawing down the liquid coating composition with a Baker bar at a setting of from about 4 to about 20 and drying it in a convection oven or tunnel dryer for about 2 to about 60 minutes at from about 35 to about 105° C to obtain films ranging from about 0.5 mil to about 3 mils thick. The dry film may then be laminated onto a dielectric substrate such as a polyimide film or an epoxy resin impregnated glass fiber board at room temperature or at an elevated temperature, e.g., 180° F (82° C). A Hot Roll (DYNACHEM Model 300 or 360) laminator may be used at a speed of 1 to 5 feet per minute, a roll pressure of 40 to 60 psi (0.28-0.41 MPa), and a roll temperature of 225 to 300° F (113-150° C). Vacuum laminators, such as models 724 and 730 sold by Morton International, Inc. may be used, also. In conventional vacuum lamination, in addition to heat and vacuum, mechanical pressure is brought to bear against the dry film. In what is known as a "slap down" process, a rubber blanket is used to press the dry film against the substrate. During vacuum lamination, the photoimageable dielectric dry film is heated to a board surface temperature of 55-90°C with a cycle time of 30-90 seconds and a slap down cycle of 4-12 seconds. A post lamination bake may last for about 30 minutes at about 90° C (194° F) but it may be eliminated under certain conditions. The laminate is then irradiated through a mask in an image pattern by ultraviolet light and developed as described above.

High resolution relief images including openings that are approximately equal to the thickness of the coating may thus be achieved. By use of such coatings, imaged openings for interconnections and conductors can be of a size equivalent to the resolution capability of the dielectric coating and the method of imaging and may be in any desired shape.

Adhesion of metal to the dielectric coating may be enhanced by a permanganate process which includes a conditioning step (also known as solvent swell), an etching step, and a neutralizing step. The conditioner may be a mixture of diethylene glycol butyl ether, phosphoric acid, surfactant, and water. Suitable conditioners are available under the trademarks COPPERMERSE M3 and CIRCUPOSIT MLB 211. Suitable potassium permanganate etching solutions are available under the trademarks COPPERMERSE M4 and CIRCUPOSIT MLB 213. Suitable neutralizers are sold under the trademarks COPPERMERSE M6 and CIRCUPOSIT MLB 216. The COPPERMERSE products are sold by LeaRonal, Inc. The CIRCUPOSIT products are sold by Shipley Co.

Selective metal deposition in the imaged openings may be performed in a conventional manner. It is characterized by the selective metallization of the relief image of the dielectric coating without an increase in the surface resistivity of an underlying substrate between conductor lines. Plating can occur only on those areas where the resist has been removed (additive production of the circuits), or on the entire surface including areas where the resist was removed by development as well as upon the resist itself (subtractive production of the circuits) or some degree of plating falling between these extremes (semi-additive production of the circuits). For a discussion of the specifics of circuitry and interconnect creation see U.S. Pat. No. 4,847,114 (Brach et al).

It is preferred for adhesion enhancement to bake after electroless metal deposition and after subsequent build up metallization processes @ 145°C-160°C for 30 to 60 minutes

If the additive process is chosen, then plating will occur in those areas where the photoimageable dielectric coating has been removed by development and upon the surface of the dielectric in a defined manner such that defined circuitry and interconnects are created. Thus, the plating itself will define the circuitry and other features desired. In the additive process, the photoimaging of the permanent dielectric will create and define the circuitry and other surface features desired as well as the holes and vias which will interconnect the various layers of the circuitry package.

If the substrate to be coated is a circuit, the process may comprise formation of a dielectric coating over a circuit with imaged openings defining interconnections. The walls of the imaged openings in the dielectric coatings contain metal as it deposits during plating and assures a desired cross sectional shape of the deposit. The process is repeated sequentially to form sequential layers of circuits and interconnections.

In the subtractive procedure, the entire surface will be plated. The circuitry and other features will be defined by subsequent etching of the plated metal. In the subtractive manner, the photodefinition of the permanent resist will typically be used for the creation of holes and vias which connect the various layers of the circuitry package, thus eliminating the need for drilling holes.

The plating solution is typically an electroless copper plating solution well known in the art and typically comprises a source of cupric ions, a complexing agent to hold the ions in solution, a reducing agent to reduce the cupric ions to metallic copper in the presence of the catalyst-e.g., formaldehyde and a pH adjustor. Typical copper plating solutions are disclosed in U.S. Patent Nos. 4,834,796; 4,814,009; 4,684,440; and 4,548,644.

The coating composition and process of this invention are further described in the following examples, which are not limiting in any way. All parts are by weight unless otherwise indicated and all components are 100 % solids unless otherwise indicated.

EXAMPLE 1

The following composition was prepared:

| Component | Wt.% solids |
|---|---|
| Cresol novolac (Schenectady Resins HRJ10805) | 50.1 |
| Epoxy novolac (EPON 164) | 4.9 |
| Epoxidized polybutadiene (POLY BD 605) | 19.8 |
| Butylated novolac (SANTOLINK 560) | 14.3 |
| Diazonaphthoquinone sulfonate of 2,1,5-trihydroxybenzophenone | 9.9 |
| DAI HFA (CD-1012) | 1.0 |
| | 100.0 |

| Filler | Wt % of total solids above |
|---|---|
| Silica (SYLOID 7000) | 5.0 |

| Solvent | Wt % of total composition |
|---|---|
| Propylene glycol methylether acetate | 46-48 |

The coating composition was mixed thoroughly and applied to a glass/epoxy laminate by a wire wound drawdown bar to a dry thickness of 1-2 mils. The coating was then dried at 90° C (194° F) for 30 minutes and exposed imagewise to patterned actinic radiation from a broad band mercury vapor lamp (ORC H10W201B). The total radiation dosage was about 400 mj/cm$^2$. The exposed surface was then immersed in an aqueous 0.2 N solution of sodium hydroxide at 95° F for about 2 minutes, thereby selectively removing the exposed portions of the coating. The developed coating was cured at 311° F (155° C) for one hour. The coating survived three successive 5-minute immersions of a conventional permanganate process.

## EXAMPLE 2

A photoimageable dielectric coating composition of this invention is made according to the following formulation:

| Component | Wt % solids |
|---|---|
| Cresol novolac resin | 46.0 |
| Epoxidized polybutadiene | 20.0 |
| Epoxidized novolac resin | 10.0 |
| Butylated novolac resin | 10.0 |
| Diazonaphthoquinone | 10.0 |
| Diaryiodonium hexafluoroantimonate | 1.0 |
| Levelling agent | 0.2 |
| Fillers, colorants, additives | 2.8 |

A solution similar to that of Example 1 is coated on each of six of the epoxy/glass laminates and then dried, irradiated, developed and cured as in that example to give six innerlayers suitable for electroless plating and assembly with compression into a multilayered printed circuit board of this invention.

## EXAMPLE 3

The following composition was prepared:

| Component | Wt.% solids |
|---|---|
| Cresol novolac (Schenectady Resins HRJ10805) | 60.0 |
| Epoxy novolac (EPON 164) | 10.0 |
| Butylated novolac (SANTOLINK 560) | 15.0 |

(continued)

| Component | Wt.% solids |
|---|---|
| Diazonaphthoquinone sulfonate of 2,1,5-trihydroxybenzophenone | 12.5 |
| DAI HFA (CD-1012) | 1.0 |
| Levelling agent (Modaflow) | 1.5 |
| | 100.0 |

| Filler | Wt % of total solids above |
|---|---|
| Silica (CAB-O-SIL M5) | 8.0 |

| Solvent | Wt % of total composition |
|---|---|
| Propylene glycol methylether acetate | 47.4 |

The coating composition was mixed thoroughly and applied to a glass/epoxy laminate by a wire wound drawdown bar to a dry thickness of 1-2 mils. The coating was then dried at 100° C (194° F) for 30 minutes and exposed imagewise to patterned actinic radiation from a broad band mercury vapor lamp (ORC H10W201B). The total radiation dosage was about 400 mj/cm$^2$. The exposed surface was then immersed in an aqueous 0.25 N solution of sodium hydroxide at 86° F for about 2 minutes, thereby selectively removing the exposed portions of the coating. The developed coating was cured at 311° F (155° C) for one hour. The coating survived three successive 5-minute immersions of a conventional permanganate process. This composition afforded better resolution and a better sidewall profile than that of Example 1.

## Claims

1. A positive-tone photoimageable dielectric coating composition comprising a novolac resin, a crosslinkable resin, a naphthoquinonediazide, and a curing catalyst comprising dicyandiamide and/or a thermally labile halogen-containing compound or mixture of compounds, selected from diaryliodonium hexafluoroantimonate; tribromomethyl-phenylsulfone; trichloroacetamide; bis-chloroimidazole; 2,4-(trichloromethyl)-4-methoxyphenyl-6-triazine and 2,4-(trichloromethyl)-4-methoxynaphthyl-6-triazine; 2,4-(trichloromethyl)-piperonyl-6-triazine.

2. A photoimageable dielectric composition according to claim 1 wherein the naphthoquinonediazide comprising from 5 to 30 % by weight of the total composition.

3. A photoimageable dielectric composition according to claim 1 or claim 2 wherein the curing catalyst is diaryliodonium hexafluoroantimonate and the amount of curing catalyst comprises from 0.1 to 2 % by weight of the total composition.

4. A photoimageable dielectric composition according to any preceding claim wherein the crosslinkable resin is an epoxy resin and the amount of the crosslinkable resin is from 5 to 40 % by weight of the total composition.

5. A dielectric coating composition according to any preceding claim wherein the novolac resin comprises from 30 to 80 % by weight of the total composition.

6. A photoimageable dielectric composition according to any preceding claim comprising, by weight, from 45 to 70 % of a cresol novolac resin.

7. A photoimageable dielectric composition according to claim 6 comprising, by weight, 46 % of a cresol novolac resin, 20 % of an epoxidized polybutadiene, about 10% of the naphthoquinonediazide, about 1 % of diaryliodonium hexafluoroantimonate, from 8 to 12 % of an epoxidized novolac, and from 8 to 12 % of a butylated phenolic novolac.

8. A positive-tone photoimaged dielectric innerlayer for a multiple layered printed circuit board, said innerlayer comprising a cured mixture of a novolac resin, a crosslinking resin, the products of radiation induced decomposition of a naphthoquinonediazide, and dicyandiamide or the products of a thermal decomposition of a thermally labile halogen-containing curing catalyst.

9. An innerlayer according to claim 8 wherein the novolac resin comprises from 30 to 80 % by weight of the cured mixture.

10. An innerlayer according to claim 9 wherein the novolac resin comprises 45 to 70 % by weight of the cured mixture.

11. An innerlayer according to any one of claims 8 to 10 wherein the crosslinking resin was an epoxy resin.

12. An innerlayer according to claim 10 wherein the epoxy resin comprised from 5 to 40 % by weight of the mixture before curing.

13. An innerlayer according to claim 11 wherein the crosslinking resin was an epoxidized polybutadiene in an amount of from 15 to 25 % by weight.

14. A multilayered printed circuit board of claim 13 wherein said innerlayers comprise a cured mixture of a novolac resin, an epoxy resin, the products of radiation induced decomposition of a naphthoquinonediazide, and the products of the thermal decomposition of a halogen-containing curing catalyst selected from the group consisting of diaryliodonium hexafluoroantimonate; tribromomethyl-phenylsulfone; trichloroacetamide; bis-chloroimidazole; 2,4-(trichloromethyl)-4-methoxyphenyl-6-triazine; 2,4-(trichloromethyl)-4-methoxynaphthyl-6-triazine; 2,4-(trichloromethyl)-piperonyl-6-triazine, and mixtures thereof.

15. An innerlayer according to claim 14 wherein the mixture comprised, before curing, about 46 % of a cresol novolac resin, about 20 % of the epoxidized polybutadiene, about 8 to 12 % of an epoxidized novolac, from 8 to 12 % of a butylated phenolic novolac, and from 0.5 to 1.5 % by weight of a diaryliodonium hexafluoroantimonate.

16. A multilayered printed circuit board comprising a plurality of positive-tone photoimaged dielectric innerlayers according to any preceding claim, each of said photoimaged innerlayers defining lines, holes and vias; said lines, holes and vias being plated with a conductive metal.

**European Patent Office**

**EUROPEAN SEARCH REPORT**

Application Number

EP 98 30 1153

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DATABASE WPI<br>Section Ch, Week 9420<br>Derwent Publications Ltd., London, GB;<br>Class A21, AN 94-161410<br>XP002066330<br>& JP 06 102 662 A (SANPUKU CO LTD)<br>* abstract * | 1-6,<br>8-12,14,<br>16 | G03F7/022 |
| X | EP 0 530 148 A (CIBA GEIGY AG ;OCG<br>MICROELECTRONICS INC (US)) 3 March 1993<br><br>* claims 1,6,7; example 22 * | 1-6,<br>8-12,14,<br>16 | |
| A | DATABASE WPI<br>Section Ch, Week 8609<br>Derwent Publications Ltd., London, GB;<br>Class A12, AN 86-058537<br>XP002066331<br>& JP 61 009 648 A (HITACHI LTD)<br>* abstract * | 1,7,13,<br>15 | |
| A | PATENT ABSTRACTS OF JAPAN<br>vol. 011, no. 134 (P-571), 28 April 1987<br>& JP 61 275749 A  (NEC CORP), 5 December 1986,<br>* abstract * | 1,7,15 | **TECHNICAL FIELDS SEARCHED** (Int.Cl.6)<br><br>G03F |
| A | PATENT ABSTRACTS OF JAPAN<br>vol. 097, no. 004, 30 April 1997<br>& JP 08 319307 A  (NIPPON KAYAKU CO LTD),<br>3 December 1996,<br>* abstract * | 1 | |
| A | EP 0 565 858 A (SHIPLEY CO) 20 October 1993<br>* claims 1-3 * | 7,13,15 | |
| | -/-- | | |

The present search report has been drawn up for all claims

| Place of search | Date of completion of the search | Examiner |
|---|---|---|
| THE HAGUE | 28 May 1998 | Philosoph, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 98 30 1153

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int.Cl.6) |
| A | US 5 532 105 A (YAMADERA TAKASHI ET AL) 2 July 1996<br>* column 5, line 8 - line 60 *<br>* column 7, line 66 - column 8, line 4 *<br>----- | | |
| | | | **TECHNICAL FIELDS SEARCHED (Int.Cl.6)** |

The present search report has been drawn up for all claims

| Place of search | Date of completion of the search | Examiner |
|---|---|---|
| THE HAGUE | 28 May 1998 | Philosoph, L |

EPO FORM 1503 03.82 (P04C01)